**Europäisches Patentamt**

**European Patent Office**

**Office européen des brevets**

(11) Numéro de publication : **0 614 091 A1**

# (12) DEMANDE DE BREVET EUROPEEN

(21) Numéro de dépôt : **94400458.9**

(22) Date de dépôt : **03.03.94**

(51) Int. Cl.⁵ : **G01R 33/24**

(30) Priorité : **05.03.93 FR 9302591**

(43) Date de publication de la demande :
**07.09.94 Bulletin 94/36**

(84) Etats contractants désignés :
**BE CH DE DK GB LI SE**

(71) Demandeur : **COMMISSARIAT A L'ENERGIE ATOMIQUE**
**31-33, rue de la Fédération**
**F-75015 Paris (FR)**

(72) Inventeur : **Duret, Denis**
**13, rue de Stalingrad**
**F 38100 Grenoble (FR)**

(74) Mandataire : **Signore, Robert**
**c/o BREVATOME**
**25, rue de Ponthieu**
**F-75008 Paris (FR)**

(54) **Magnétomètre différentiel à résonance.**

(57) Le magnétomètre différentiel de l'invention comprend un ensemble de référence (ENSr) et au moins un ensemble de mesure (ENSm). Le courant de polarisation engendré par le premier est le même que le courant de polarisation utilisé dans le second. Le signal de contre-réaction produit par le second donne directement la différence entre les champs.
Application en magnétométrie.

FIG. 7

**Domaine technique**

La présente invention a pour objet un magnétomètre différentiel à résonance. Elle trouve une application dans la mesure relative des champs magnétiques faibles, par exemple de quelques dizaines de microteslas, c'est-à-dire dans la mesure des variations spatiales et/ou temporelles de tels champs.

L'invention trouve des applications en géophysique, en prospection minière, en détection spatiale, en médecine, etc.

**Etat de la technique antérieure**

Le magnétomètre de l'invention est de préférence du type directionnel à résonance. Ces appareils sont bien connus et décrits, par exemple, dans la demande de brevet français FR-2 663 751 déposée par le présent Demandeur (cette demande contenant elle-même des références bibliographiques sur le sujet), ou dans la demande européenne correspondante EP-A-463 919, ou encore dans l'article de D. DURET, M. MOUSSAVI et M. BERANGER intitulé "Use of High Performance Electron Spin Resonance Materials for the Design of Scalar and Vectorial Magentometers", publié dans la revue IEEE Transactions on Magnetics, vol. 27, n° 6, nov. 1991, pp. 5405-5407.

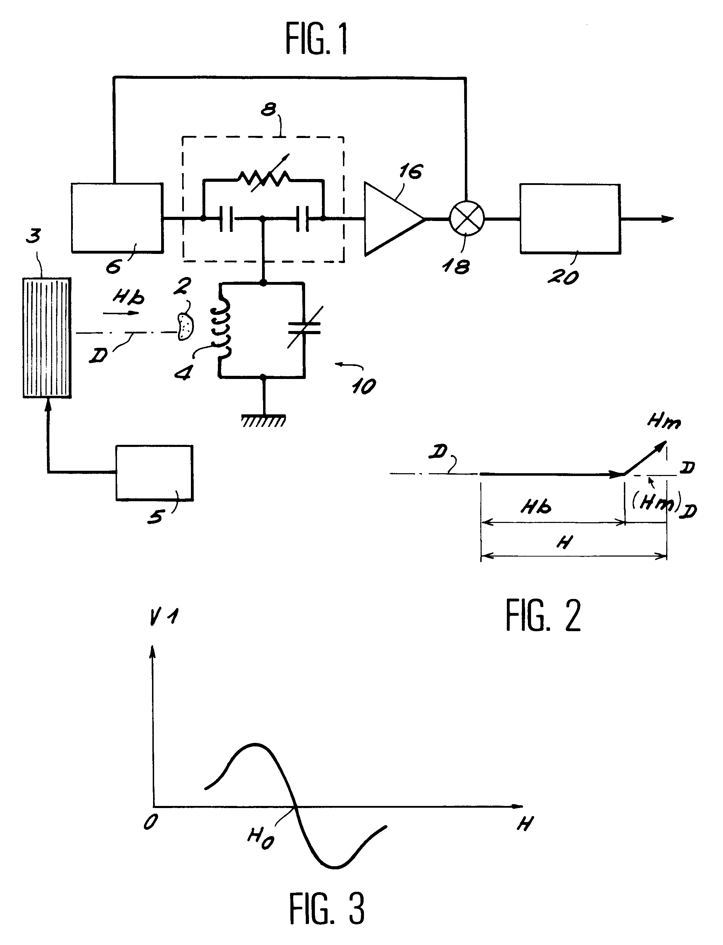

On peut rappler brièvement la structure et le fonctionnement de ces appareils dans quelques une de leurs variantes et ceci en référence aux figures 1 à 6 annexées.

Sur la figure 1, tout d'abord, on voit un échantillon 2 contenant un matériau possédant des spins électroniques ou nucléaires ; un premier enroulement 3 créant un champ magnétique de polarisation noté Hb et dirigé selon une direction D ; un second enroulement 4 à proximité de l'échantillon 2 ; un générateur de courant 5 d'intensité réglable alimentant le premier enroulement 3 ; un générateur haute-fréquence 6 relié à un pont de mesure 8, lequel est relié à son tour à un circuit résonnant 10 contenant l'enroulement 4 ; un amplificateur à faible bruit 16 relié au pont de mesure 8 ; un mélangeur équilibré 18 recevant, d'une part, la tension délivrée par l'amplificateur 16, et, d'autre part, une tension de référence émanant du générateur haute-fréquence 6 ; et, enfin, un filtre passe-bas 20.

L'échantillon 2 est soumis au champ à mesurer, soit Hm, ainsi qu'au champ de polarisation Hb. Ces deux champs ne sont pas en général colinéaires. Le champ magnétique mesuré par un tel appareil est, en fait, la somme de Hb et de la composante de Hm projetée sur la direction D, composante notée $(Hm)_D$, compte tenu du fait que Hb est beaucoup plus grand que Hm dans le cas d'un magnétomètre directionnel. Ces divers champs ou composantes sont représentés sur la figure 2. Le champ total dans la direction D est noté H.

Le fonctionnement de cet appareil est le suivant.

Le générateur 6, connecté au circuit 10 et à son enroulement 4, est apte à exciter la résonance des spins de l'échantillon 2. Sa fréquence est fixée avec une très grande précision ($10^{-9}$ à $10^{-6}$). La résonance des spins se produit lorsque la fréquence fo du signal d'excitation est égale à la fréquence de LARMOR, classiquement déterminée par la relation $(1/(2\,\gamma))$ Ho, où $\gamma$ est le rapport gyromagnétique propre à l'échantillon utilisé (dans le cas de l'électron $\gamma=2\,\pi.28$ GHz/T) et Ho est la valeur à la résonance du champ magnétique total appliqué.

Le circuit 10 et son enroulement 4 sont, en même temps, aptes à détecter cette résonance, le circuit 8 ayant pour fonction de découpler l'excitation et la détection.

L'appareil représenté sur la figure 1 détecte le passage par la résonance lorsque, la fréquence fo étant fixée, le champ total H passe par la valeur Ho. La figure 3 montre ainsi les variations e la tension Vl délivrée par le filtre passe-bas 20 lorsque le champ H varie et passe par Ho. Cette courbe est du type dispersion, c'est-à-dire antisymétrique, avec une partie positive, une annulation (pour la valeur Ho correspondant à la résonance) et une partie négative. La connaissance de Ho permet de remonter à $(Hm)_D$ si l'on connaît Hb.

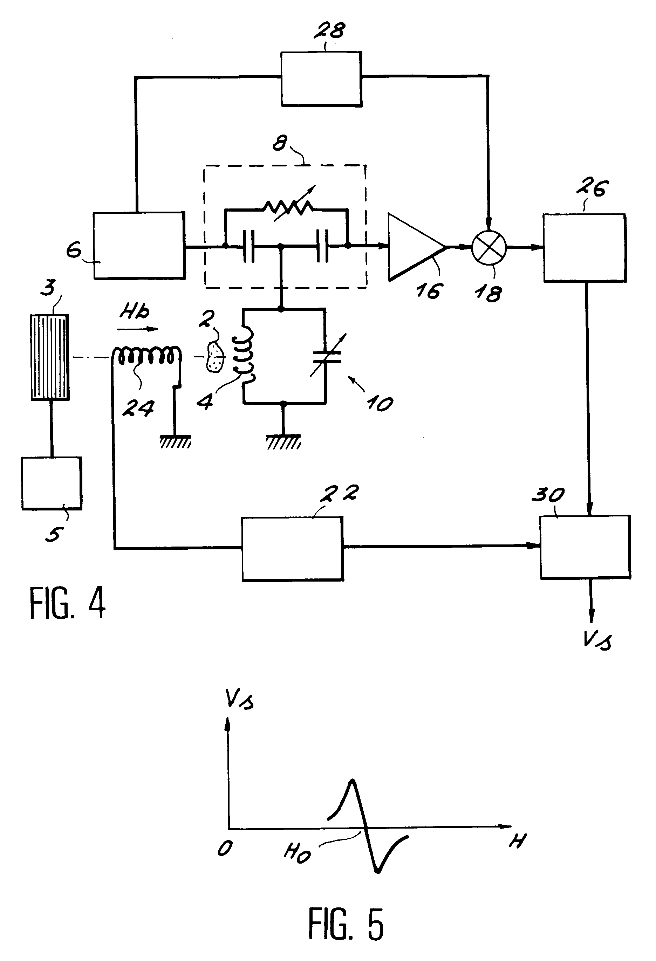

Le dispositif de la figure 4 est une variante dans laquelle on utilise en outre un oscillateur 22 et un enroulement 24 pour engendrer un champ magnétique ayant une fréquence-audio noté fm, ce champ, appelé "champ d'agitation", se superposant au champ de polarisation Hb.

Par ailleurs, dans la variante de la figure 4 et à la sortie du mélangeur équilibré 18, le filtre passe-bas 20 de la figure 1 est remplacé par un filtre passe-bande 26 centré autour de la fréquence fm. Un déphaseur 28 reçoit le signal de haute fréquence issu du générateur 6 et fournit au mélangeur équilibré 18 un signal de phase appropriée.

Un autre circuit 30 de détection synchrone à la fréquence fm reçoit sur l'une de ses entrées un signal de référence issu du générateur 22. Ce signal de référence possède une fréquence fm mais son amplitude et sa phase peuvent être rendues différentes de celles du signal fourni par l'oscillateur 22 à la bobine 24. Le circuit 30 possède une autre entrée reliée à la sortie du filtre 26 et il délivre finalement une tension Vs.

En montant à la sortie du moyen de détection synchrone 30 un moyen d'observation approprié (non représenté), on peut observer la courbe des variations de Vs en fonction du champ total H. Cette courbe est représentée sur la figure 5. Comme celle de la figure 3, il s'agit d'une courbe antisymétrique avec annulation pour la valeur Ho du champ correspondant à la résonance des spins.

Avec de tels appareils, une variation du champ à mesurer Hm, si elle est très inférieure à la largeur des raies représentées sur les figures 3 et 5, se traduit par un écart par rapport à la valeur à la résonance et par l'apparition d'une tension (Vl ou Vs) non nulle en sortie du magnétomètre. Cette tension varie sensiblement linéairement en fonction de l'écart à Ho.

La linéarité peut être améliorée par une contre-réaction de champ, obtenue en se servant de la tension Vl (figure 3) ou de la tension Vs (figure 5) comme signal d'erreur, en intégrant cette tension et en injectant, dans une bobine de contre-réaction, un courant proportionnel à la tension intégrée. L'axe de cette bobine de contre-réaction doit encore être parallèle à la direction D du champ de polarisation.

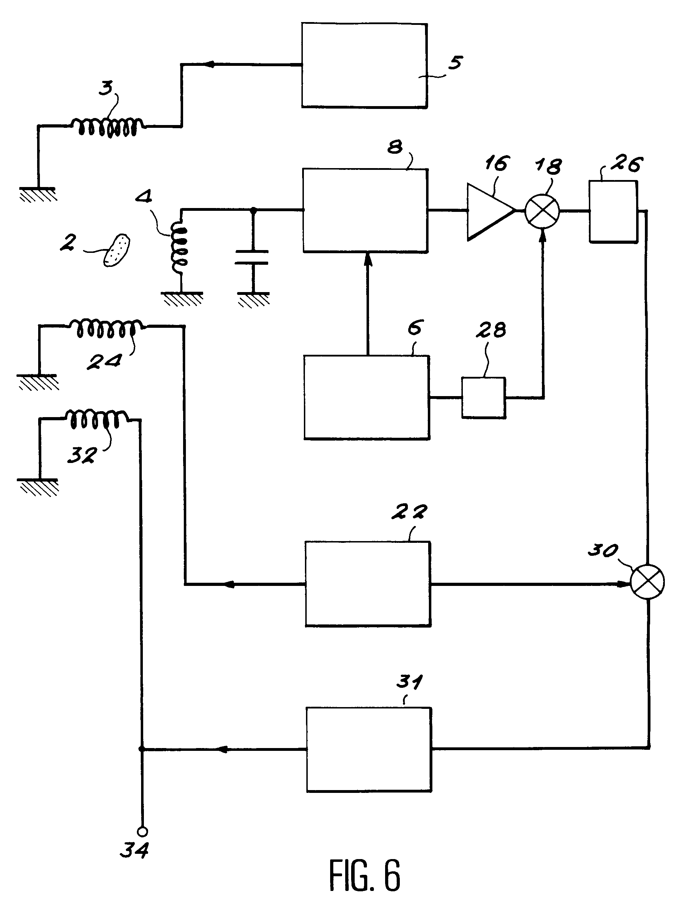

C'est ce qu'on trouve dans le schéma de la figure 6 où apparaissent, en plus des moyens déjà représentés sur la figure 4, un intégrateur 31 et un enroulement 32 de contre-réaction. Dans un tel appareil, le champ total est toujours maintenu à la valeur correspondant à la résonance et le signal d'erreur intégré constitue en fait le signal de mesure. Ce dernier apparaît sur la sortie 34 de l'appareil.

En d'autres termes, quel que soit le champ appliqué de l'extérieur à l'échantillon, cet échantillon voit, le long de la direction D, le même champ, à savoir celui qui assure la résonance des spins. Comme le champ correspondant à la résonance est beaucoup plus grand (plus de dix fois) que le champ d'origine extérieure à mesurer, le module de la somme vectorielle (cf. fig. 2) est sensiblement égal à la somme du champ créée par le courant de polarisation et dirigé selon la direction D et de la projection sur cette direction du champ extérieur à mesurer.

Autrement dit, les moyens 31 et 32 réalisent un asservissement de l'appareil à la résonance, quel que soit le champ appliqué de l'extérieur.

On peut noter encore que, dans le mode de réalisation illustré sur la figure 6, les trois enroulements, respectivement de polarisation 3, d'agitation 24 et de contre-réaction 32, sont supposés distincts ; mais comme ils ont tous le même axe, ils peuvent très bien être confondus en un seul et même enroulement.

Quant à l'intégrateur 31, il peut soit délivrer directement le courant de contre-réaction, soit délivrer une tension, auquel cas il faut lui associer un convertisseur tension-courant, sous la forme par exemple d'une résistance.

On retiendra de cet exposé de l'état de la technique, que les magnétomètres directionnels à résonance connus comprennent en général un échantillon à spins soumis au champ à mesurer, des moyens pour appliquer à cet échantillon un champ magnétique de polarisation, des moyens pour appliquer à l'échantillon un champ radiofréquence et exciter la résonance des spins, des moyens pour détecter cette résonance, des moyens pour engendrer un signal électrique antisymétrique qui s'annule lorsque le champ total appliqué à l'échantillon prend la valeur Ho correspondant à la résonance des spins et qui est positif ou négatif selon que le champ total appliqué est plus grand ou plus petit que cette valeur particulière (Ho). En l'absence de champ à mesurer, l'appareil est réglé pour être à la résonance. En présence d'un champ à mesurer, le champ de contre-réaction rétablit la résonance et la valeur du signal d'erreur intégré (ou du courant de contre-réaction) constitue la mesure du champ magnétique.

Pour réaliser un magnétomètre différentiel avec les appareils qui viennent d'être décrits, il faut disposer deux tels appareils en deux points distincts et faire la différence des signaux obtenus.

Or, les deux chaînes de mesures utilisées dans ces deux appareils ne seront pas en général parfaitement identiques, de sorte qu'une part du signal de différence obtenu sera en réalité due à des différences de structure des deux appareils. Par ailleurs, la différence calculée étant faible devant les deux grandeurs séparément mesurées, cette différence devra être calculée avec une très grande précision pour être significative.

## Exposé de l'invention

La présente invention a justement pour but de remédier à ces inconvénients. A cette fin, elle propose de combiner deux magnétomètres directionnels à résonance (tels que ceux qui viennent d'être décrits) de telle manière que la différence de champ que l'on désire mesurer apparaisse directement en un point du circuit, sans qu'il soit besoin d'extraire deux signaux de mesure et d'en faire la différence.

Pour ce faire, le magnétomètre différentiel de l'invention comprend un premier ensemble, dit de référence, et au moins un second ensemble, dit de mesure, ces deux ensembles étant combinés l'un à l'autre de telle sorte que le courant de polarisation du magnétomètre de référence soit imposé au magnétomètre de mesure, celui-ci se trouvant dès lors hors de la résonance, et délivrant de ce fait un signal d'erreur qui traduit directement l'écart des champs auxquels sont soumis les deux magnétomètres.

De façon plus précise, la présente invention a pour objet un magnétomètre différentiel comprenant :

A) un premier ensemble, dit de référence, comprenant :

- un premier échantillon à spins placé en certain premier point (A),
- des premiers moyens pour appliquer à cet échantillon un champ magnétique de polarisation (Hp), ces premiers moyens étant parcourus par un certain courant (Ip),
- des premiers moyens d'excitation et de détection de la résonance des spins dans le premier échantillon et de délivrance d'un premier signal (Vr) qui est nul lorsque le champ appliqué au premier échantillon à la valeur (Ho) correspondant à la résonance des spins du premier échantillon placé au point A et positif ou négatif lorsque le champ appliqué s'écarte de cette valeur (Ho),
- des premiers moyens de contre-réaction aptes à créer un premier champ de contre-réaction rétablissant la valeur (Ho) du champ (H) correspondant à la résonance ;

B) au moins un deuxième ensemble, dit de mesure, comprenant :
- un deuxième échantillon à spins placé en certain deuxième point (B) écarté du premier (A), ce deuxième échantillon étant similaire au premier,
- des deuxièmes moyens pour appliquer à ce deuxième échantillon un champ magnétique de polarisation (Hp), ces deuxièmes moyens étant identiques aux premiers, orientés parallèlement aux premiers et parcourus par le même courant (Ip),
- des deuxièmes moyens d'excitation et de détection de la résonance des spins dans le deuxième échantillon, ces deuxièmes moyens étant à la même fréquence que les premiers et étant aptes également à délivrer un signal qui est nul lorsque le champ appliqué au deuxième échantillon a la valeur (Ho) correspondant à la résonance des spins du deuxième échantillon placé au point B et qui est positif ou négatif lorsque le champ appliqué s'écarte de la valeur (Ho),
- des deuxièmes moyens de contre-réaction aptes à créer un deuxième champ de contre-réaction rétablissant la valeur $(Ho)_B$ du champ correspondant à la résonance des spins dans le deuxième échantillon,
- une sortie reliée auxdits deuxièmes moyens de contre-réaction, cette sortie délivrant un signal correspondant au champ de contre-réaction et qui est proportionnel à la différence des champs présents aux premier et au deuxième points (A, B).

## Brève description des dessins

- la figure 1 montre une variante de magnéto-mètre directionnel à résonance selon l'art antérieur ;
- la figure 2 montre la composition des différents champs en présence ;
- la figure 3 illustre une courbe de dispersion autour de la résonance ;
- la figure 4 montre une autre variante de magnétomètre selon l'art antérieur avec champ d'agitation ;
- la figure 5 illustre la courbe de dispersion obtenue avec un magnétomètre de ce dernier type ;
- la figure 6 montre encore une autre variante de magnétomètre selon l'art antérieur avec champ d'agitation et champ de contre-réaction ;
- la figure 7 est un schéma général d'un magnétomètre différentiel conforme à l'invention ;
- la figure 8 illustre un mode de réalisation d'un magnétomètre différentiel selon l'invention à trois ensembles de mesure disposés en trièdre tri-rectangle.

## Exposé détaillé de modes de réalisation

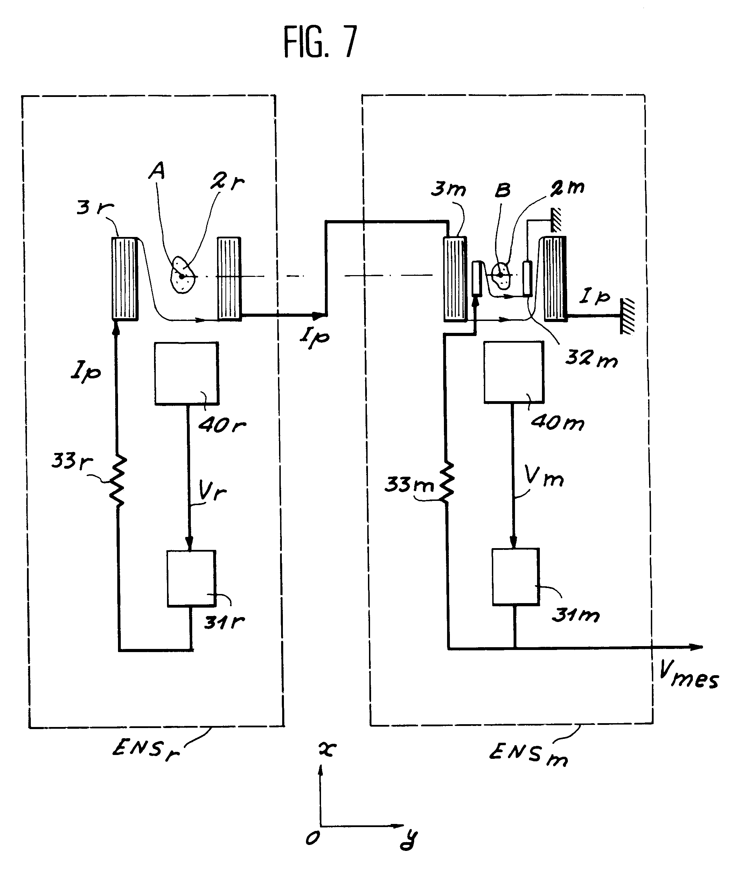

La figure 7 est un schéma général d'un magnétomètre différentiel conforme à l'invention dans le cas où il n'existe qu'un seul ensemble de mesure. L'appareil représenté comprend un ensemble de référence, noté ENSr, et un ensemble de mesure, noté ENSm. Les deux ensembles comprennent sensiblement les mêmes moyens, référencés de la même manière, avec un indice r pour l'ensemble de référence et un indice m pour l'ensemble de mesure. On trouve ainsi deux échantillons identiques 2r, 2m (à spins électroniques ou nucléaires) placés en deux points distincts A et B, deux enroulements de polarisation 3r, 3m d'axes parallèles, l'enroulement 3r créant en outre le champ de contre-réaction et un enroulement de contre-réaction 32m.

Par ailleurs, chaque ensemble comprend des moyens déjà utilisés dans l'art antérieur et symbolisés par les blocs référencés 40r et 40m. Il faut comprendre qu'il s'agit là des moyens déjà décrits à propos des figures 1, 4 et 6, moyens pris seuls ou en combinaison, (incluant éventuellement des moyens d'agitation) et qui permettent d'exciter la résonance, de la détecter et de fournir un signal (Vr, Vm) s'annulant lorsque le champ magnétique total prend la valeur Ho correspondant à la résonance.

Les deux ensembles comprennent encore des intégrateurs 31r, 31m, supposés travailler en tension et des convertisseurs tension-courant représentés sous forme de résistances 33r, 33m.

Un courant Ip circule dans l'enroulement 3r. Comme cet enroulement est connecté en série avec l'enroulement 3m, ce même courant parcourt ce dernier enroulement.

4

Au lieu de connecter les enroulements 3r, 3m en série, on pourrait les disposer indépendamment et les alimenter par deux sources de courant identiques, de même consigne.

Quant au fonctionnement des circuits 40r et 40m à la même fréquence, il peut se faire en reliant les différents moyens entre eux (fonctionnement de type maître/esclave), soit en reliant ces moyens à des mêmes moyens telle qu'une horloge, soit encore en préréglant ces moyens à la même fréquence.

Le fonctionnement du magnétomètre différentiel de la figure 7 est le suivant.

Si le champ à mesurer est le même aux points A et B, le premier ensemble ENSr délivre au second ENSm un courant de polarisation Ip qui est précisément le courant assurant la résonance dans l'ensemble ENSm. La tension mesurée Vmes en sortie de 31m est donc nulle, ce qui traduit bien la nullité de la différence des champs en A et en B.

Si, au contraire, le champ en B est différent du champ en A, le courant Ip engendré par l'ensemble de référence ENSr ne correspondra plus à la résonance dans l'ensemble de mesure ENSm. Un signal d'erreur sera donc présent en sortie du circuit de contre-réaction et de l'intégrateur 31m. Le signal d'erreur Vmes sera la traduction de la différence de champ entre les points A et B.

On peut préciser ces considérations en repérant le champ à mesurer par ses composantes et ses variations selon deux axes Ox, Oy représentés en bas de la figure 7. l'axe Oy est dirigé selon le segment AB.

Le champ magnétique extérieur peut être représenté par un vecteur $\overrightarrow{Hex}$ au point A et $\overrightarrow{Hex}$ + $\overrightarrow{Hy}$ au point B.

Au point A, le champ dans l'axe défini par la bobine 3r peut s'exprimer par :

$$\overrightarrow{Ho} = \Upsilon fo = \overrightarrow{H_p} + (1/H_p)(\overrightarrow{Hex}.\overrightarrow{H_p}), \quad (1)$$

$H_p$ étant le champ dû au courant de contre-réaction $I_p$ :

$$H_p = K\frac{Vr}{R} = KIp \quad (2)$$

où K est le coefficient de transfert de la bobine 3r (respectivement 3m) reliant le champ magnétique créé dans cette bobine par $I_p$ et R est la résistance de 33r (respectivement 33m).

L'expression (1) est une approximation au premier ordre, valable si Ho est très supérieur à Hex.

Au point B, le champ dans l'axe défini par la bobine 3m peut s'exprimer par :

$$\overrightarrow{H} = \overrightarrow{H_p} + (1/H_p)((\overrightarrow{Hex} + \overrightarrow{\Delta Hy}).\overrightarrow{H_p}) \quad (3)$$

$$\overrightarrow{H} = \overrightarrow{H_p} + 1/H_p (\overrightarrow{Hex}.\overrightarrow{H_p}) + (1/H_p)(\overrightarrow{\Delta Hy}.\overrightarrow{H_p}) \quad (4)$$

En combinant les relations (4) et (1), on obtient :

$$\overrightarrow{H} = Ho + (1/H_p)(\overrightarrow{\Delta Hy}.\overrightarrow{H_p}) \quad (5)$$

ΔHy représentant la variation de Hex selon l'axe AB.

Si la distance d entre A et B tend vers zéro, la quantité $(1/H_p)$ $\overrightarrow{Hy}.\overrightarrow{H_p}$ tend vers la dérivée partielle $\dfrac{\delta Hex|x}{\delta y}$ ,

Hex|x étant la composante de Hex selon l'axe x. Cette dérivée est une composante du tenseur gradient du champ magnétique.

Si la projection du champ suivant x ne varie pas selon l'axe y, l'expression (5) devient H = Ho et la tension Vm est nulle puisque le système B est maintenu à la résonance. Par contre, une variation selon l'axe y se traduit par une tension conforme à la figure 5. Cette tension peut être utilisée directement dans sa partie linéaire comme tension de sortie du magnétomètre différentiel : elle est alors proportionnelle à la quantité $(1/H_p)$ $(\Delta \overrightarrow{Hy} . \overrightarrow{H_p})$.

Sinon, l'ensemble de mesure ENSm est maintenu à la résonance par le signal de contre-réaction délivré par l'ensemble 31m, 33m et l'on a

$$H = Ho = Ho + (1/H_p)(\Delta \overrightarrow{Hy}.\overrightarrow{H_p}) + Hcr \qquad (6)$$

Hcr étant le champ de contre-réaction créé par la bobine 32m. On peut noter que la bobine 32m peut être confondue avec la bobine 3m, si l'on ajoute les courants Ip et Icr.

D'après (6), on obtient :

$$(1/H_p)(\Delta \overrightarrow{Hy}.\overrightarrow{H_p}) = -Hcr \qquad (7)$$

La tension Vmes est donc bien proportionnelle à la quantité à mesurer.

On a ainsi réalisé une mesure différentielle directe, sans avoir à effectuer la différence précise de deux quantités données par deux chaînes de mesure magnétométriques identiques. Par ailleurs, on peut remarquer que le problème de la stabilité des dimensions de la bobine 3r ou 3m, intervenant sur le facteur K de l'équation (2), et qui est important dans le cas d'un magnétomètre à résonance non différentiel, n'intervient pas, dans la mesure où les bobines 3r et 3m sont identiques et soumises à la même température : la quantité Hp est identique en A et en B.

Il est possible de réaliser simultanément des mesures différentielles en plusieurs points de l'espace par rapport à la même référence située en un point A. Il suffit de positionner plusieurs ensembles tels que ENSm en d'autres points, avec leurs bobines de polarisation parcourues par le même courant que l'ensemble de référence.

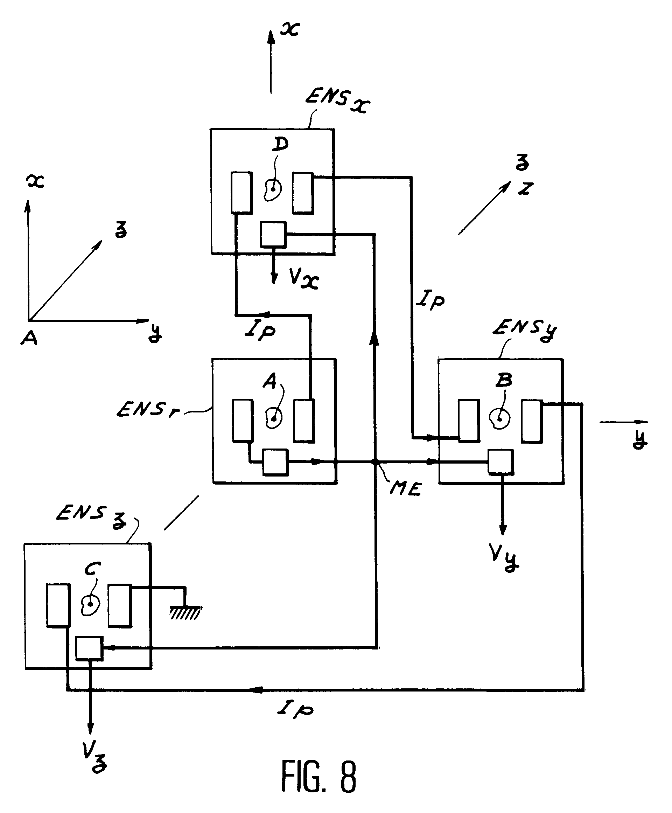

C'est ce qui est représenté sur la figure 8 où l'on voit un ensemble de référence ENSr placé autour d'un point A et trois ensembles de mesure respectivement ENSx, ENSy, ENSz placés en trois points B, C et D disposés sur trois axes formant un trièdre trirectangle Ax, y, z. Les trois ensembles de mesure reçoivent tous le même courant de polarisation Ip formé par exemple dans l'ensemble de référence et délivrent trois signaux Vx, Vy, Vz qui traduisent les variations du champ selon les trois axes Ax, Ay, Az.

Dans la figure 8, les moyens d'excitation et de détection des différents ensembles sont à la même fréquence grâce à un fonctionnement de type maître/esclave. Dans cette représentation, le maître correspond à l'ensemble ENSr et les esclaves correspondent aux autres ensembles ENSx, ENSy, ENSz.

## Revendications

1. Magnétomètre différentiel à résonance comprenant un premier ensemble, dit de référence (ENSr), comportant :
   - un premier échantillon à spins (2r) placé en premier point (A),
   - des premiers moyens (3r) pour appliquer à cet échantillon (2r) un champ magnétique (Hb) de polarisation, ces premiers moyens (3r) étant parcourus par un certain courant (Ip),
   - des premiers moyens (40r) d'excitation et de détection de la résonance des spins dans ce premier échantillon (2r) et de délivrance d'un premier signal (Vr) qui est nul lorsque le champ appliqué au premier échantillon (2r) a une valeur (Ho) correspondant à la résonance, et positif ou négatif lorsque le champ appliqué s'écarte de cette valeur (Ho),
   - des premiers moyens de contre-réaction (31r, 33r, 3r) aptes à créer un premier champ de contre-réaction rétablissant la valeur (Ho) du champ (H) correspondant à la résonance,
   ce magnétomètre étant caractérisé par le fait qu'il comprend en outre au moins un deuxième ensemble, dit de mesure (ENSm), comportant :
   - un deuxième échantillon à spins (2m) placé en deuxième point (B) écarté du premier (A), ce deuxième échantillon (2m) étant similaire au premier (2r),
   - des deuxièmes moyens (3m) pour appliquer à ce deuxième échantillon un champ magnétique (Hb) de polarisation, ces deuxièmes moyens étant identiques aux premiers, orientés parallèlement aux premiers et parcourus par le même courant (Ip),

- des deuxièmes moyens (40m) d'excitation et de détection de la résonance des spins dans le deuxième échantillon (2m), à la même fréquence que les premiers moyens (40r) d'excitation et de détection de la résonance des spins dans le premier échantillon (2r), ces deuxièmes moyens (40m) délivrant un signal (Vm) qui est nul lorsque le champ appliqué au deuxième échantillon (2m) a la valeur (Ho) correspondant à la résonance des spins du deuxième échantillon et positif ou négatif lorsque le champ appliqué (H) s'écarte de la valeur (Ho),
- des deuxièmes moyens de contre-réaction (31m, 32m) aptes à créer un deuxième champ de contre-réaction rétablissant la valeur (Ho) du champ (H) correspondant à la résonance dans le deuxième échantillon (2m),
- une sortie reliée auxdits deuxièmes moyens de contre-réaction (31m), cette sortie délivrant un signal (Vmes) proportionnel à la différence des champs présents au premier et au deuxième points (A, B).

2. Magnétomètre selon la revendication 1, caractérisé par le fait que les premiers moyens (3r) pour appliquer un champ de polarisation (Hb) au premier échantillon (2r) de l'ensemble de référence (ENSr) sont reliés en série avec les deuxièmes moyens (3m) pour appliquer un champ de polarisation au deuxième échantillon (2m) de l'ensemble de mesure (ENSm).

3. Magnétomètre selon la revendication 1, caractérisé par le fait que les premiers moyens (3r) pour appliquer un champ de polarisation au premier échantillon (2r) de l'ensemble de référence (ENSr) et les deuxièmes moyens (3m) pour appliquer un champ de polarisation au deuxième échantillon (2m) de l'ensemble de mesure (ENSm) sont alimentés par deux sources de courant identiques de même consigne.

4. Magnétomètre selon la revendication 1, caractérisé par le fait que les premiers et les deuxièmes moyens d'excitation et de détection de la résonance (40r, 40m) de l'ensemble de référence (ENSr) et de l'ensemble de mesure (ENSm) sont connectés les uns aux autres de façon à ce que les uns imposent leur fréquence d'excitation et de détection aux autres.

5. Magnétomètre selon la revendication 1, caractérisé par le fait que les premiers et les deuxièmes moyens d'excitation et de détection de la résonance (40r, 40m)de l'ensemble de référence (ENSr) et de l'ensemble de mesure (ENSm) sont alimentés par des mêmes moyens de façon à leur imposer une même fréquence d'excitation et de détection.

6. Magnétomètre selon la revendication 1, caractérisé par le fait que l'ensemble de mesure (ENSm) comprend un enroulement de contre-réaction spécifique (32m) relié aux deuxièmes moyens (31m, 33m) aptes à créer le deuxième champ de contre-réaction.

7. Magnétomètre selon la revendication 1, caractérisé par le fait qu'il comprend un troisième ensemble constituant un deuxième ensemble de mesure et disposé autour d'un troisième point (C) distant du premier (A) et du deuxième (B).

8. Magnétomètre selon la revendication 7, caractérisé par le fait qu'il comprend un quatrième ensemble constituant un troisième ensemble de mesure et disposé autour d'un quatrième point (D) distant du premier (A), du deuxième (B) et du troisième (C).

9. Magnétomètre selon la revendication 8, caractérisé par le fait que les quatre points (A, B, C, D) forment un trièdre trirectangle autour desquels sont disposés l'ensemble de référence (ENSr) et les trois ensembles de mesure (ENSx, ENSy, ENSz).

10. Magnétomètre selon la revendication 1, caractérisé en ce que chacun des ensembles du magnétomètre comporte en outre des moyens d'excitation (40r, 40m) aptes à créer un champ d'agitation de même direction que le champ de polarisation créé dans ledit ensemble.

11. Magnétomètre selon la revendication 1, caractérisé en ce que les premier et second moyens d'excitation et de détection sont pré-réglés à la même fréquence.

## FIG. 1

## FIG. 2

## FIG. 3

FIG. 4

FIG. 5

FIG. 6

# FIG. 7

FIG. 8

EP 0 614 091 A1

Office européen des brevets

**RAPPORT DE RECHERCHE EUROPEENNE**

Numero de la demande

EP 94 40 0458

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.5) |
|---|---|---|---|
| Y | US-A-4 114 087 (M.G.J. FRY) <br> * abrégé * <br> * colonne 3, ligne 14 - ligne 64 * <br> * colonne 5, ligne 64 - colonne 6, ligne 8 * <br> * colonne 7, ligne 47 - colonne 8, ligne 36 * <br> * figures 7-11 * | 1,2 | G01R33/24 |
| A | | 3-5 | |
| Y,D | EP-A-0 463 919 (COMMISSARIAT A L'ENERGIE ATOMIQUE) <br> * colonne 6, ligne 3 - colonne 8, ligne 34; figures 5,7 * | 1,2 | |
| A | US-A-4 260 949 (M.L. DALTON) <br> * colonne 3, ligne 5 - colonne 4, ligne 16 * <br> * colonne 10, ligne 44 - colonne 13, ligne 54; figures 1,2 * | 1-5 | |
| A | US-A-2 856 579 (M.E. PACKARD) <br> * colonne 2, ligne 52 - colonne 4, ligne 28; figures 1,3,4 * | 1-5 | **DOMAINES TECHNIQUES RECHERCHES (Int.Cl.5)** <br><br> G01R |
| A | FR-A-2 583 885 (COMMISSARIAT A L'ENERGIE ATOMIQUE) <br> * page 7, ligne 2 - page 8, ligne 19; figures 2,3 * | 1,2,7,8 | |
| A | US-A-2 975 360 (W.E. BELL) <br> * colonne 1, ligne 65 - colonne 2, ligne 23 * <br> * colonne 5, ligne 66 - colonne 6, ligne 56; figures 1,2,7 * | 1-5 | |

Le présent rapport a été établi pour toutes les revendications

| Lieu de la recherche | Date d'achèvement de la recherche | Examinateur |
|---|---|---|
| LA HAYE | 19 Mai 1994 | Horak, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

    & : membre de la même famille, document correspondant

EPO FORM 1503 03.82 (P04C02)

13